# EUROPÄISCHE PATENTANMELDUNG

(11) **EP 1 612 936 A2**
(43) Veröffentlichungstag der Anmeldung: **04.01.2006**
(21) Anmeldenummer: 05012047.6
(22) Anmeldetag: 03.06.2005
(51) Int. Cl.: H03K 5/135

(54) **Taktsteuerzelle**

(30) Priorität: 30.06.2004 DE 102004031669
(71) Anmelder: Infineon Technologies AG, 81669 München (DE)
(72) Erfinder: Siegler, Sascha, 82008 Unterhaching (DE); Weber, Gerhard, 85635 Höhenkirchen (DE); Baumann, Thomas, 85609 Aschheim (DE); Bergler, Stefan, 81669 München (DE)
(74) Vertreter: Patentanwälte Lambsdorff & Lange

(57) **Zusammenfassung**

Eine Taktsteuerzelle (T) zur Erzeugung eines Ausgangs-Taktsignals (CLK2) aus einem Eingangs-Taktsignal (CLK1), mit einem Halteglied (2) und einer Ausgangsstufe (1) ist dadurch gekennzeichnet, dass dem Halteglied (2) ein Signalpegelumsetzer (NOR1) vorgeschaltet ist, wobei der Signalpegelumsetzer (NOR1) derart ausgelegt ist, dass er ein Eingangssignal in ein Ausgangssignal (A) mit vorgegebenen Signalpegeln umsetzt, und das Eingangs-Taktsignal (CLK1) das Eingangssignal des Signalpegelumsetzers (NOR1) ist.

## Beschreibung

Die Erfindung betrifft eine Taktsteuerzelle, an welche Signale mit undefinierten Spannungspegeln angelegt werden können, ohne darin Querströme zu verursachen.

In der Halbleiter-Technik nimmt die Integrationsdichte, d.h. die Anzahl und die Dichte der in integrierten Schaltkreisen verwendeten Bauelemente immer weiter zu. Zudem werden Leckströme in den neuen Halbleiter-Technologien immer größer. Um den Energieverbrauch und die Wärmeentwicklung von integrierten Schaltkreisen zu begrenzen, müssen daher Konzepte zur Begrenzung der Leistungsaufnahme von integrierten Schaltkreisen gefunden werden.

Dazu ist es bekannt, das Taktsignal in zeitweise nicht genutzten Bereichen bzw. Blöcken oder Registerbänken des integrierten Schaltkreises auszublenden bzw. abzuschalten, um die Schaltaktivität und die damit verbundenen Schaltströme in diesen nicht genutzten Blöcken zu vermindern bzw. vollständig zu unterbinden. Prinzipiell würde dazu ein einfaches AND-Gatter (NAND-Gatter mit Inverter) ausreichen, durch welches ein an einem ersten Eingang anliegendes Taktsignal durch ein an einem zweiten Eingang anliegendes Freigabe-Signal ausgeblendet werden kann. Das Freigabe-Signal ist jedoch mit dem Taktsignal nicht synchronisiert, wodurch beim Ein- und Ausblenden des Taktsignals durch das Umschalten des FreigabeSignals im Allgemeinen zusätzliche Flanken ("glitches") im Taktsignal am Ausgang des AND-Gatters auftreten.

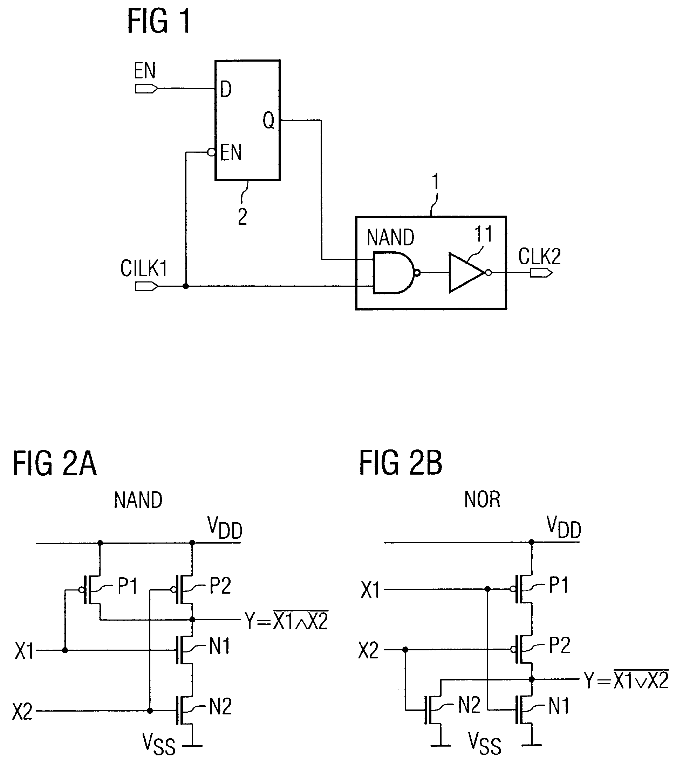

Zur synchronisierten Ein- und Ausblendung von Taktsignalen ist die Verwendung einer Taktsteuerzelle ("gated clock cell"), wie in Fig. 1 dargestellt, bekannt. Der Ausgangsstufe 1, welche ein NAND-Gatter NAND und einen Inverter 11 umfasst, wird ein Halteglied ("latch") 2, welches das unsynchronisierte Freigabesignal EN mit dem Eingangs-Taktsignal CLK1 synchronisiert, vorgeschaltet. Das Ausgangssignal des Haltegliedes 2 ändert nur dann seinen Wert, wenn das Eingangs-Taktsignal CLK1 den logischen Wert Null annimmt. Zu diesem Zeitpunkt behält das Ausgangssignal der Ausgangsstufe 1 bei Änderungen des Ausgangssignals des Haltegliedes 2 den logischen Wert Null bei und im Ausgangs-Taktsignal CLK2 treten keine zusätzliche Flanken ("glitches") auf.

Vor Allem bei neueren Entwicklungen soll die Möglichkeit bestehen, in zeitweise nicht genutzten Bereichen bzw. Blöcken die Versorgungsspannung abzuschalten oder die Versorgungsspannung dem momentanen Spannungsbedarf, entsprechend der momentanen Aufgabe des Blocks, anzupassen, d.h. im Allgemeinen abzusenken.

Eine Veränderung der Versorgungsspannung eines Block hat entsprechend veränderte Spannungspegel der logischen Werte innerhalb dieses Blocks zur Folge, da die Spannungspegel meist in Abhängigkeit von der Versorgungsspannung definiert sind. Im Normalfall sind der Spannungspegel der logischen Eins identisch mit der Versorgungsspannung und der Spannungspegel der logischen Null identisch mit Masse.

Die Versorgungsspannungen verschiedener Blöcke sollen dabei unabhängig voneinander variiert oder abgeschaltet werden. Dadurch werden beispielsweise in miteinander verbundenen Blöcken gleiche logische Signale durch unterschiedliche Spannungspegel dargestellt. Somit stellen im allgemeinen Fall die Spannungspegel der logischen Signalwerte eines Blocks für den jeweils anderen Block undefinierte Signalwerte dar. Zudem fallen Spannungen, welche den logischen Signalwert eins darstellen, nach dem Abschalten eines Blocks nur langsam ab und bilden in diesem Zeitraum somit undefinierte, logische Signalwerte für einen benachbarten Block. Dies kann in dem benachbarten Block zu sehr großen Quer- bzw. Kurzschlussströmen, verbunden mit einem hohen Leistungsverbrauch und einer starken Wärmeentwicklung, führen. Insbesondere in logischen CMOS-Schaltungen verschwindet der Querstrom nur dann, wenn die Spannungspegel der Eingangssignale außerhalb eines bestimmten, zwischen den Spannungspegeln der logischen Signalwerte liegenden Spannungsbereichs liegen.

Aufgabe der Erfindung ist es, eine Taktsteuerzelle zu schaffen, an welche undefinierte, logische Signalwerte angelegt werden können ohne Querströme innerhalb der Taktsteuerzelle zu verursachen und insbesondere zusätzliche Flanken ("glitches") auf dem Taktsignal zu vermeiden.

Die der Erfindung zugrunde liegende Aufgabe wird durch die Merkmale des Hauptanspruchs gelöst. Vorteilhafte Weiterbildungen und Ausgestaltungen sind in den Unteransprüchen angegeben.

In der erfindungsgemäßen Taktsteuerzelle zur Erzeugung eines Ausgangs-Taktsignals aus einem Eingangs-Taktsignal, mit einem Halteglied zur Erzeugung eines gesteuerten Freigabesignals aus einem Eingangs-Freigabesignal, und einer Ausgangsstufe zur Erzeugung des Ausgangs-Taktsignals aus dem Eingangs-Taktsignal und dem gesteuerten Freigabesignal, ist dem Halteglied ein Signalpegelumsetzer vorgeschaltet, wobei der Signalpegelumsetzer derart ausgelegt ist, dass er ein Eingangssignal in ein Ausgangssignal umsetzt und das Eingangs-Taktsignal das Eingangssignal des Signalpegelumsetzers ist. Das Ausgangssignal des Signalpegelumsetzers weist dabei vorgegebene Signalpegel auf, das heißt es nimmt zu einem gegebenen Zeitpunkt nur einen aus einer definierten Menge von erlaubten Signalpegeln an.

Der Signalpegelumsetzer setzt dabei insbesondere Signale mit möglicherweise undefinierten Spannungspegeln in definierte Signalpegel um. Somit liegen zu jedem Zeitpunkt an dem Halteglied definierte Signalwerte an. Querströme innerhalb des Haltegliedes werden somit unterbunden.

Bei der bislang bekannten Taktsteuerzelle können beim Anliegen eines Eingangs-Taktsignals mit undefinierten Spannungspegeln zumindest am Eingang des Haltegliedes Quer- bzw. Kurzschlussströme fließen. Bei der erfindungsgemäßen Taktsteuerzelle werden diese durch das Vorsehen des Signalpegelumsetzers vermieden. Dies ist vor Allem dann von Vorteil, wenn ein Taktpfad eines integrierten Schaltkreises durch verschiedene Blöcke verläuft und die verschiedenen Blöcke des integrierten Schaltkreises mit verschiedenen Versorgungsspannungen betrieben oder abgeschaltet werden.

In einer vorteilhaften Ausgestaltung der erfindungsgemäßen Taktsteuerzelle weist der Signalpegelumsetzer eine steuerbare Einheit zur Unterbindung von Querströmen auf. Diese Einheit ist dazu ausgelegt, Querströme innerhalb des Signalpegelumsetzers bei Bedarf zu unterbinden.

Die Vorrichtung zur Unterbindung von Querströmen ist Teil des Signalpegelumsetzers bzw. im Allgemeinen Teil einer logischen Schaltung und wird von einem Steuersignal gesteuert. Wird die Vorrichtung zur Unterbindung von Querströmen geeignet angesteuert, so können die Eingangssignale der logischen Schaltung beliebige, auch undefinierte Spannungspegel annehmen, ohne innerhalb der logischen Schaltung Querströme zu verursachen.

In einer weiteren vorteilhaften Ausgestaltung der erfindungsgemäßen Taktsteuerzelle umfasst diese eine Eingangsstufe, welche den Signalpegelumsetzer und eine Steuereinheit umfasst. Die Steuereinheit steuert dabei die Einheit zur Unterbindung von Querströmen des Signalpegelumsetzers in Abhängigkeit vom Eingangs-Freigabesignal.

Wird die Taktsteuerzelle durch das Eingangs-Freigabesignal abgeschaltet, so erzeugt die Steuereinheit der Eingangsstufe ein geeignetes Steuersignal für die Einheit zur Unterbindung von Querströmen des Signalpegelumsetzers. Die Eingangssignale des Signalpegelumsetzers können daraufhin beliebige Spannungspegel annehmen, ohne Querströme innerhalb des Signalpegelumsetzers zu verursachen.

In einer weiteren vorteilhaften Ausgestaltung der erfindungsgemäßen Taktsteuerzelle steuert die Steuereinheit die Einheit zur Unterbindung von Querströmen des Signalpegelumsetzers zusätzlich in Abhängigkeit vom gesteuerten Freigabesignal.

Dadurch wird gewährleistet, dass eine Veränderung des Ausgangssignals des Signalpegelumsetzers derart mit dem Eingangs-Taktsignal synchronisiert wird, dass zusätzliche Flanken ("glitches") im Ausgangs-Taktsignal vermieden werden.

Vorzugsweise weist die Ausgangsstufe, welche wenigstens eine weitere logische Schaltung umfasst, eine weitere Einheit zur Unterbindung von Querströmen innerhalb der Ausgangsstufe auf.

Dadurch können auch an der Ausgangsstufe undefinierte Signalpegel, wie sie insbesondere im Eingangs-Taktsignal auftreten können, anliegen, ohne Querströme in der Ausgangsstufe zu verursachen. Die Einheit zur Unterbindung von Querströmen innerhalb der Ausgangsstufe ist dabei vorzugsweise Teil einer logischen Schaltung am Eingang der Ausgangsstufe.

Eine weitere vorteilhafte Ausgestaltung der erfindungsgemäßen Taktsteuerzelle sieht vor, dass das Eingangs-Taktsignal ausschließlich an solchen logischen Schaltungen anliegt, welche eine Einheit zur Unterbindung von Querströmen aufweisen.

Diese Maßnahme gewährleistet, dass in der gesamten erfindungsgemäßen Taktsteuerzelle Querströme beim Auftreten von undefinierten Spannungspegeln im Eingangs-Taktsignal unterbunden werden.

In einer weiteren vorteilhaften Ausgestaltung der erfindungsgemäßen Taktsteuerzelle ist vorgesehen, dass eine Einheit zur Unterbindung von Querströmen jeweils eine steuerbare Schalteinheit umfasst, welche den Stromfluss zwischen zwei gemeinsamen festen Potentialen unterbrechen bzw. verhindern kann. Ein der steuerbaren Schalteinheit zugeführtes Steuersignal steuert dabei das Unterbrechen bzw. Verhindern des Stromflusses bzw. das Unterbrechen der Strompfade der jeweiligen logischen Schaltung durch die Schalteinheit. Vorzugsweise umfassen alle in der erfindungsgemäßen Taktsteuerzelle vorgesehenen Einheiten zur Unterbindung von Querströmen eine solche steuerbare Schalteinheit.

Die Schalteinheit unterbindet somit einen möglichen Stromfluss zwischen den beiden Potentialen innerhalb einer logischen Schaltung. Sind die Strompfade unterbrochen so, können die Eingangssignale der logischen Schaltung beliebige, auch undefinierte Spannungspegel annehmen, ohne innerhalb der logischen Schaltung Querströme zu verursachen.

Die zwei gemeinsamen festen Potentiale können beispielsweise das Massepotential und das Versorgungspotential der logischen Schaltung sein.

In logischen Schaltungen mit einer Vorrichtung zur Unterbindung von Querströmen führen alle Strompfade, d.h. alle denkbaren Wege, über die ein Strom von dem ersten gemeinsamen festen Potential, insbesondere dem Versorgungspotential, der logischen Schaltung zum zweiten gemeinsamen festen Potential, insbesondere dem Massepotential, fließen kann, durch die Schalteinheit. Die Schalteinheit ist somit in allen Strompfaden seriell zu den übrigen Bauteilen des jeweiligen Strompfades geschaltet. Diese kann daher den Stromfluss in allen Strompfaden und somit den gesamten Stromfluss innerhalb der logischen Schaltung von dem Versorgungspotential zu dem Massepotential unterbrechen. Die Schalteinheit umfasst dabei wenigstens ein Schaltelement bzw. einen Schalter, beispielsweise einen Schalttransistor. Umfasst die Schalteinheit mehrere Schaltelemente, so werden diese vorzugsweise zeitgleich geschaltet. Im einfachsten Fall besteht die Schalteinheit aus genau einem Schaltelement, beispielsweise einem Schalttransistor, durch welches alle Strompfade der logischen Schaltung führen. Damit ist die Unterbrechung aller Strompfade und somit die Unterbindung möglicher Quer- bzw. Kurzschlussströmen gewährleistet.

Weiterhin ist das Ausgangssignal der logischen Schaltung konstant, wenn das Steuersignal der Einheit zur Unterbindung von Querströmen dessen Schalteinheit veranlasst, alle Strompfade zu unterbrechen. Die logischen Eingangssignale haben in diesem Fall keinen Einfluss auf das Ausgangssignal der logischen Schaltung. Dadurch werden Schaltaktivitäten und die damit verbundenen Schaltströme innerhalb der logischen Schaltung sowie in nachgeschalteten Schaltungselementen minimiert. Das Steuersignal stellt somit ein den logischen Eingangsignalen übergeordnetes Signal dar. Insbesondere weist in diesem Fall das Ausgangssignal der logischen Schaltung einen definierten Signalpegel auf.

Die logische Schaltung mit einer Einheit zur Unterbindung von Querströmen kann besonders einfach als NAND- oder NOR-Gatter aufgebaut sein. Dadurch wird ein besonders einfacher Aufbau der logischen Schaltung ermöglicht. Die Vorrichtung zur Unterbindung von Querströmen umfasst dabei einen ersten der seriell angeordneten Schalt-Transistoren. Das Steuersignal bildet dann ein Eingangssignale des Gatters, insbesondere desjenigen, welches den ersten der seriell angeordneten Schalt-Transistoren steuert.

Im Falle eines NAND-Gatters wird zur Unterbindung von Querströmen das Steuersignal bzw. eines der logischen Eingangssignale auf eine logische Null gesetzt. Dadurch werden alle Strompfade innerhalb des NAND-Gatters unterbrochen und Quer-oder Kurzschlussströme unterbunden. Das logische Ausgangssignal nimmt, unabhängig von den möglicherweise undefinierten Spannungspegeln der übrigen logischen Eingangssignale, den logischen Wert eins an.

Im Falle eines NOR-Gatters wird zur Unterbindung von Querströmen das Steuersignal bzw. eines der logischen Eingangssignale auf eine logische Eins gesetzt. Dadurch werden alle Strompfade innerhalb des NOR-Gatters unterbrochen und Quer-oder Kurzschlussströme unterbunden. Das logische Ausgangssignal nimmt, unabhängig von den möglicherweise undefinierten Spannungspegeln der übrigen logischen Eingangssignale, den logischen Wert null an.

Gemäß einer weiteren vorteilhaften Ausgestaltung der Taktsteuerzelle weist das erzeugte Ausgangs-Taktsignal ausschließlich synchron zum Eingangs-Taktsignal liegende Flanken auf. Das Ausgangs-Taktsignal wird aus dem Eingangs-Taktsignal abgeleitet und das An- und Abschalten des Ausgangs-Taktsignals geschieht in Abhängigkeit von dem Eingangs-Taktsignal bzw. synchronisiert mit diesem. Soll ein Ausgangs-Taktsignal ausgegeben werden, so wird im einfachsten Fall das Eingangs-Taktsignal im Wesentlichen direkt als Ausgangs-Taktsignal verwendet. Soll kein Ausgangs-Taktsignal ausgegeben werden, so verbleibt der Ausgang der erfindungsgemäßen Taktsteuerzelle auf einem konstanten Signalpegel. Der Wechsel von dem an- in den abgeschalteten Zustand und zurück wird so vorgenommen, dass das Ausgangs-Taktsignal im Vergleich mit dem Eingangs-Taktsignal keine zusätzlichen Flanken aufweist. Bei einer zeitweisen Abschaltung des Ausgangs-Taktsignals werden die gleiche Anzahl von fallenden und ansteigenden Flanken des Eingangs-Taktsignals ausgeblendet. Ist das Ausgangs-Taktsignal abgeschaltet, so kann das Eingangs-Taktsignal beliebige Spannungspegel aufweisen, ohne Querströme in der erfindungsgemäßen Taktsteuerzelle zu verursachen.

Insbesondere nimmt das Ausgangs-Taktsignal spätestens im Anschluss an die nächste Flanke des Eingangs-Taktsignals einen konstanten Signalpegel an, wenn das Eingangs-Freigabesignal die Taktsteuerzelle bzw. den Takt abschaltet.

Die erfindungsgemäße Taktsteuerzelle bietet eine der herkömmlichen Taktsteuerzelle entsprechende Funktionalität. Zusätzlich bietet sie den Vorteil, dass beim Anliegen von EingangsTaktsignalen mit undefinierten Spannungspegeln keine Quer-oder Kurzschlussströme innerhalb der logischen Schaltungen der erfindungsgemäßen Taktsteuerzelle fließen.

Zur Vermeidung von zusätzlichen Flanken auf dem Taktpfad findet das Abschalten des Taktsignals in der Eingangs- und Ausgangsstufe synchron zum Eingangs-Taktsignal statt. Das Einschalten der Eingangsstufe erfolgt hingegen asynchron, damit der schaltungsinterne Takt bzw. das Steuersignal für das Halteglied wieder zur Verfügung stehen. Die Ausgangsstufe wird synchron zum Eingangs-Taktsignal freigeschaltet. Dies wird durch die Eingangsstufe gewährleistet.

Nachfolgend wird die Erfindung anhand verschiedener Zeichnungsfiguren näher erläutert. Es zeigen:
- Fig. 1: eine Taktsteuerzelle gemäß dem Stand der Technik;
- Fig. 2a: ein NAND-Gatter in CMOS-Technologie als erstes Ausführungsbeispiel einer logischen Schaltung mit einer Einheit zur Unterbindung von Querströmen;
- Fig. 2b: ein NOR-Gatter in CMOS-Technologie als zweites Ausführungsbeispiel einer logischen Schaltung mit einer Einheit zur Unterbindung von Querströmen; und
- Fig. 3: ein Ausführungsbeispiel der erfindungsgemäßen Taktsteuerzelle.

Fig. 2a zeigt ein erstes Ausführungsbeispiel einer logischen Schaltung mit einer Einheit zur Unterbindung von Querströmen in Form eines NAND-Gatters in CMOS-Technologie. Obwohl das gezeigte NAND-Gatter zwei Eingänge X1 und X2 besitzt, kann die Erfindung auch auf NAND-Gatter mit einer beliebigen Anzahl von Eingängen angewandt werden. Das NAND-Gatter besteht aus einer Parallelschaltung von PMOS-Transistoren P1 und P2 sowie einer Serienschaltung von NMOS-Transistoren N1 und N2. Das NAND-Gatter weist zwei Strompfade auf. Der erste Strompfad umfasst die Transistoren P1, N1 und N2, der zweite Strompfad umfasst die Transistoren P2, N1 und N2. Alle Strompfade des NAND-Gatters laufen somit durch die beiden NMOS-Transistoren N1 und N2. Die Einheit zur Unterbindung von Querströmen wird durch einen der beiden NMOS-Transistoren N1 und N2 gebildet.

Im Folgenden wird angenommen, dass NMOS-Transistor N2 die Einheit zur Unterbindung von Querströmen darstellt. Liegt am Eingang X2 eine logische Null an, so sind die Strompfade des NAND-Gatters geöffnet. Querströme, d.h. Ströme zwischen dem Versorgungspotential V_{DD} und dem Massepotential V_{SS}, können somit unabhängig vom Spannungspegel am Eingang X1 nicht fließen. Solange am Eingang X2 eine logische Null anliegt, liegt am Ausgang Y des NAND-Gatters konstant eine logische Eins an.

In Fig. 2b ist ein NOR-Gatter gezeigt, welches ein zweites Ausführungsbeispiel einer logischen Schaltung mit einer Einheit zur Unterbindung von Querströmen darstellt. Die Strompfade des NOR-Gatters können hierbei durch die Serienschaltung der PMOS-Transistoren P1 und P2, beispielsweise durch den PMOS-Transistor P2, welcher von dem Eingangssignal X2 gesteuert wird, unterbrochen werden. Liegt am Eingang X2 eine logische Eins an, so ist der PMOS-Transistor P2 geöffnet und Quer- bzw. Kurzschlussströme werden unabhängig vom Spannungspegel am Eingang X1 unterbrochen. Am Ausgang Y des NOR-Gatters liegt dann eine logische Null an.

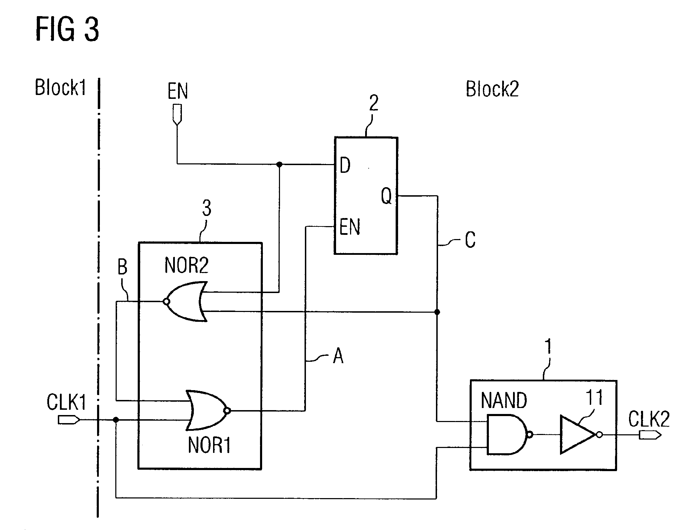

Fig. 3 zeigt ein Ausführungsbeispiel der erfindungsgemäßen Taktsteuerzelle. Die Taktsteuerzelle T nimmt neben einem Eingangs-Taktsignal CLK1 ein nicht synchronisiertes Eingangs-Freigabesignal EN entgegen und erzeugt ein Ausgangs-Taktsignal bzw. gesteuertes Taktsignal CLK2.

Der Aufbau der Taktsteuerzelle T basiert auf der Schaltung der in Fig. 1 gezeigten Taktsteuerzelle. Gleiche Bauelemente sind daher in den Fig. 1 und 3 mit denselben Bezugszeichen versehen. Im Gegensatz zu der in Fig. 1 gezeigten Taktsteuerzelle ist bei der erfindungsgemäßen Taktsteuerzelle T dem Halteglied 2 eine Eingangsstufe 3 vorgeschaltet. Die Eingangsstufe 3 ist aus NOR-Gattern NOR1 und NOR2 aufgebaut. Die Eingänge des NOR-Gatters NOR2 sind mit dem Eingangs-Freigabe-signal EN und dem Ausgang Q des Halteglieds 2 verbunden. Der Ausgang des NOR-Gatters NOR2 ist an einen Eingang des NOR-Gatters NOR1 geschaltet. Der andere Eingang des NOR-Gatters NOR1 wird von dem Eingangs-Taktsignal CLK1 gespeist. Der Ausgang des NOR-Gatters NOR1 ist mit dem Steuereingang EN des Halteglieds 2 verbunden.

Ein weiterer wesentlicher Unterschied zwischen den in den Fig. 1 und 3 dargestellten Taktsteuerzellen besteht darin, dass das NAND-Gatter NAND und das NOR-Gatter NOR1 der Taktsteuerzelle T jeweils eine Einheit zur Unterbindung von Querströmen aufweisen. Zu diesem Zweck sind in dem vorliegenden Ausführungsbeispiel das NAND-Gatter NAND durch das in Fig. 2a dargestellte NAND-Gatter und das NOR-Gatter NOR1 durch das in Fig. 2b dargestellte NOR-Gatter realisiert.

Zum einfacheren Verständnis der nachfolgend beschriebenen Funktionsweise der Taktsteuerzelle T sind in Fig. 3 einige der von den dort dargestellten Bauelementen erzeugten Signale mit Bezugszeichen versehen. So erzeugen die NOR-Gatter NOR1 und NOR2 an ihren Ausgängen ein Steuersignal A bzw. B. Das Halteglied 2 stellt an seinem Ausgang Q ein gesteuertes Freigabesignal C zur Verfügung. Das Eingangs-Taktsignal CLK1 wird von Bauelementen bereitgestellt, welche der Taktsteuerzelle T vorgeschaltet sind und Teil eines Blocks 1 eines integrierten Schaltkreises sind. Die Taktsteuerzelle T selbst und die der Taktsteuerzelle T nachgeschalteten Bauelemente sind Teil eines Blocks 2 des integrierten Schaltkreises. Die Grenze zwischen den Blöcken 1 und 2 ist in Fig. 3 durch eine gestrichelte Linie gekennzeichnet.

Zunächst wird der Fall betrachtet, dass Block 2 mit dem Taktsignal CLK1 aus Block 1 versorgt werden soll. Das Eingangs-Freigabesignal EN hat den Wert Eins. Das Steuersignal B hat den Wert Null unabhängig vom Wert des gesteuerten Freigabesignals C. Dadurch ist das NOR-Gatter NOR1 sensitiv für das Eingangs-Taktsignal CLK1, d.h. das NOR-Gatter NOR1 invertiert das Eingangs-Taktsignal CLK1. Das Steuersignal A stellt das Steuersignal für das Halteglied 2 dar. Das Halteglied 2 wird genau dann transparent, wenn das Steuersignal A eins, d.h. wenn das Eingangs-Taktsignal CLK1 null ist. Das gesteuerte Freigabesignal C übernimmt den Wert eins des Eingangs-Freigabesignals EN, woraufhin die Ausgangsstufe 1 das Eingangs-Taktsignal CLK1 durchschaltet und somit das Ausgangs-Taktsignal CLK2 erzeugt.

Im Weiteren soll das Ausgangs-Taktsignal CLK2 abgeschaltet werden, weil beispielsweise das Taktsignal von Block 2 und der eventuell nachgeschalteten Blöcke abgeschaltet oder weil der vorgeschaltete Block 1 mit einer anderen, beispielsweise niedrigeren, Versorgungsspannung V_{DD} versorgt oder ganz abgeschaltet werden soll. Das Eingangs-Freigabesignal EN wird dazu auf null geschaltet. Ist in diesem Augenblick das Eingangs-Taktsignal CLK1 gleich eins, so ist das Halteglied 2 nicht transparent. Das gesteuerte Freigabesignal C übernimmt also nicht sofort den neuen Wert des Eingangs-Freigabesignals EN. Der Ausgang des NOR-Gatters NOR2 bleibt auf null, da das gesteuerte Freigabesignal C weiterhin eins ist. Da also weiterhin das Steuersignal B gleich null ist, bleibt das NOR-Gatter NOR1 sensitiv für das Eingangs-Taktsignal CLK1 und invertiert dieses. Erst nach einer fallenden Taktflanke des Eingangs-Taktsignals CLK1 wird das Steuersignal A auf eins gesetzt und das Halteglied 2 wird transparent. Schaltet das Eingangs-Freigabesignal EN jedoch zu einem Zeitpunkt auf null, zu dem das Eingangs-Taktsignal CLK1 selbst null ist, so ist das Halteglied 2 transparent. Das gesteuerte Freigabesignal C übernimmt dann den Wert des neuen Eingangs-Freigabesignals EN und am NOR-Gatter NOR2 haben beide Eingangssignale den Wert null. Das Steuersignal B wird dadurch eins und das NOR-Gatter NOR1 insensitiv für das Eingangs-Taktsignal CLK1. Das Steuersignal A nimmt dann dauerhaft den Wert null an, unabhängig vom Eingangs-Taktsignal CLK1. Das Halteglied 2 wird somit dauerhaft intransparent für das Eingangs-Freigabesignal EN. Am NAND-Gatter NAND der Ausgangsstufe 1 liegt das gesteuerte Freigabesignal C gleich null an. Am NOR-Gatter NOR1 der Eingangsstufe 3 liegt weiterhin das Steuersignal B gleich eins an. In den logischen Elementen NOR1, NAND an denen das Eingangs-Taktsignal CLK1 anliegt, sind somit die Strompfade unterbrochen.

Wird das Eingangs-Taktsignal CLK1 durch eine erfindungsgemäße Taktsteuerzelle ausgeblendet, so ist der Takteingang von Block 2 unempfindlich gegenüber undefinierten Spannungspegeln des Eingangs-Taktsignals CLK1. Querströme bzw. Kurzschlussströme werden unterbunden, unabhängig davon, welchen Spannungspegel das Eingangs-Taktsignal CLK1 annimmt bzw. unabhängig von der Versorgungsspannung von Block 1.

Im Folgenden soll das Taktsignal CLK2 für Block 2 wieder aktiviert werden. Das Eingangs-Freigabesignal EN wird auf eins gesetzt und das Steuersignal B schaltet auf null. Dadurch wird das NOR-Gatter NOR1 wieder sensitiv für das Eingangs-Taktsignal CLK1 und das Halteglied 2 wird transparent, wenn das Eingangs-Taktsignal CLK1 null ist bzw. anderenfalls nach der nächsten (fallenden) Flanke des Eingangs-Taktsignals CLK1. Das gesteuerte Freigabesignal C übernimmt den neuen Wert eins des Eingangs-Freigabesignals EN und das Eingangs-Taktsignal CLK1 wird in der Ausgangsstufe 1 zum Ausgangs-Taktsignal CLK2 durchgeschaltet. Das Steuersignal B ändert sich durch den neuen Wert des gesteuerten Freigabesignals C nicht und das NOR-Gatter NOR1 bleibt weiterhin sensitiv für das Eingangs-Taktsignal CLK1.

Die erfindungsgemäße Taktsteuerzelle kann vor allem dann vorteilhaft eingesetzt werden, wenn ein Taktpfad durch mehrere Blöcke verläuft und die verschiedenen Blöcke möglicherweise mit verschiedenen Spannungen V_{DD} versorgt werden. Taktsteuerzellen befinden sich dabei vorzugsweise an den Blockgrenzen.

Das beschriebene Ausführungsbeispiel ist nur eine der denkbaren Realisierungen der Erfindung. Die Erfindung kann beispielsweise auch mit Flip-Flop-Schaltungen realisiert werden.

## Patentansprüche

1. Taktsteuerzelle (T) zur Erzeugung eines Ausgangs-Taktsignals (CLK2) aus einem Eingangs-Taktsignal (CLK1), mit
- einem Halteglied (2) zur Erzeugung eines gesteuerten Freigabesignals (C) aus einem Eingangs-Freigabesignal (EN), und
- einer Ausgangsstufe (1) zur Erzeugung des Ausgangs-Taktsignals (CLK2) aus dem Eingangs-Taktsignal (CLK1) und dem gesteuerten Freigabesignal (C),
**dadurch gekennzeichnet,**
- **dass** dem Halteglied (2) ein Signalpegelumsetzer (NOR1) vorgeschaltet ist, wobei
- der Signalpegelumsetzer (NOR1) derart ausgelegt ist, dass er ein Eingangssignal in ein Ausgangssignal (A) mit vorgegebenen Signalpegeln umsetzt, und
- das Eingangs-Taktsignal (CLK1) das Eingangssignal des Signalpegelumsetzers (NOR1) ist.

2. Taktsteuerzelle (T) nach Anspruch 1,
**dadurch gekennzeichnet,**
- **dass** der Signalpegelumsetzer (NOR1) eine steuerbare Einheit zur Unterbindung von Querströmen innerhalb des Signalpegelumsetzers (NOR1) aufweist.

3. Taktsteuerzelle (T) nach Anspruch 2,
**gekennzeichnet durch**
- eine Eingangsstufe (3), welche den Signalpegelumsetzer (NOR1) und eine Steuereinheit (NOR2) umfasst, wobei die Steuereinheit (NOR2) die Einheit zur Unterbindung von Querströmen in Abhängigkeit vom Eingangs-Freigabesignal (EN) steuert.

4. Taktsteuerzelle (T) nach Anspruch 3,
**dadurch gekennzeichnet,**
- **dass** die Steuereinheit (NOR2) die Einheit zur Unterbindung von Querströmen des Weiteren in Abhängigkeit vom gesteuerten Freigabesignal (C) steuert.

5. Taktsteuerzelle (T) nach einem oder mehreren der vorhergehenden Ansprüche,
**dadurch gekennzeichnet,**
- **dass** das Ausgangssignal (A) des Signalpegelumsetzers (NOR1) das Halteglied (2) und insbesondere das gesteuerte Freigabesignal (C) steuert.

6. Taktsteuerzelle (T) nach einem oder mehreren der vorhergehenden Ansprüche,
**dadurch gekennzeichnet,**
- **dass** der Signalpegelumsetzer (NOR1) und/oder die Steuereinheit (NOR2) durch NOR-Gatter realisiert sind.

7. Taktsteuerzelle (T) nach einem oder mehreren der vorhergehenden Ansprüche,
**dadurch gekennzeichnet,**
- **dass** die Ausgangsstufe (1) eine weitere Einheit zur Unterbindung von Querströmen innerhalb der Ausgangsstufe (1) aufweist.

8. Taktsteuerzelle (T) nach Anspruch 7,
**dadurch gekennzeichnet,**
- **dass** das Steuersignal der Einheit zur Unterbindung von Querströmen der Ausgangsstufe (1) das gesteuerte Freigabe-signal (C) ist.

9. Taktsteuerzelle (T) nach einem oder mehreren der vorhergehenden Ansprüche,
**dadurch gekennzeichnet**,
- das Eingangs-Taktsignal (CLK1) ausschließlich an solchen logischen Schaltungen anliegt, welche eine Einheit zur Unterbindung von Querströmen aufweisen.

10. Taktsteuerzelle (T) nach einem oder mehreren der Ansprüche 2 bis 9,
**dadurch gekennzeichnet,**
- **dass** die Einheiten zur Unterbindung von Querströmen jeweils eine steuerbare Schalteinheit zur Unterbrechung oder zur Verhinderung eines Stromflusses zwischen zwei gemeinsamen festen Potentialen (V_{DD}, V_{SS}) umfassen.

11. Taktsteuerzelle (T) nach einem oder mehreren der vorhergehenden Ansprüche,
**dadurch gekennzeichnet,**
- **dass** das Ausgangs-Taktsignal (CLK2) ausschließlich synchron zum Eingangs-Taktsignal (CLK1) liegende Flanken aufweist.

12. Taktsteuerzelle (T) nach einem oder mehreren der vorhergehenden Ansprüche,
**dadurch gekennzeichnet,**
- **dass** das Ausgangs-Taktsignal (CLK2) spätestens im Anschluss an die nächste Flanke des Eingangs-Taktsignals (CLK1) einen konstanten Signalpegel annimmt, wenn das Eingangs-Freigabesignal (EN) den Takt abschaltet.
